# EUROPEAN PATENT APPLICATION

(11) **EP 4 269 648 A1**
(43) Date of publication of application: **01.11.2023**
(21) Application number: 22171058.5
(22) Date of filing: 30.04.2022
(51) Int. Cl.: C23C 14/24, C23C 14/50

(54) **SUBSTRATE HOLDER ARRANGEMENT FOR HOLDING CURVED SUBSTRATES DURING A VACUUM COATING PROCESS AND VACUUM COATING APPARATUS HAVING SUCH SUBSTRATE HOLDER ARRANGEMENT**

(71) Applicant: Satisloh AG, 6340 Baar (CH)
(72) Inventor: BONGIORNO, Antonio, 20046 Cisliano (IT); CONGIA, Fabio, 20021 Bollate (IT); MONACO, Gianni, 20156 Milano (IT); MORENI, Franco, 21057 Olgiate Olona (IT); COREA, Antonio, 20018 Sedriano (IT); KREIS, Michael, 63584 Gründau (IT)
(74) Representative: Oppermann, Mark

(57) **Abstract**

An arrangement (10) for holding substrates (SS) curved along a main extension direction is adapted to be received in a vacuum chamber (14) of a coating apparatus (12) vis-à-vis to an evaporation source (16), and comprises a hub portion (18) rotatably drivable about a first rotational axis (RA1), arm members (20) radially extending away therefrom, and roller bodies (22) mounted on the arm members so as to be rotatably drivable about second rotational axes (RA2). The roller bodies carry fixtures (24) for holding the substrates with their main extension directions transverse to the respective second rotational axis, each arranged tiltable relative to the roller body about a tilt axis (TA) running transversely to said second rotational axis, so that an angle between a surface normal (SN) in a center (CE) of the held substrate and a perpendicular (PP) on said second rotational axis passing through the center can be adjusted.

## Description

### TECHNICAL FIELD OF THE INVENTION

The present invention generally relates to a substrate holder arrangement for holding substrates curved at least along a main extension direction during a vacuum coating process, according to the preamble portion of claim 1, and to a vacuum coating apparatus comprising such substrate holder arrangement. Such vacuum coating apparatus generally serves the purpose of high vacuum physical vapor deposition (PVD) of multilayer thin films on substrates of various materials, both organic and inorganic, usually used in optical and/or eye protective applications.

In particular, the present invention relates to a substrate holder arrangement in a box coating apparatus - also called "box coater" for short - for vacuum coating of relatively long, highly curved substrates, which can be used within the frame of large-scale production of optical and/or eye protective products, such as generic sports visors of, e.g., cylindrical or toroidal shapes, similar visors for ski helmets, bicycle helmets, motorsport, in particular motorcycle helmets, and virtual/ augmented reality helmets, etc., but not limited to these examples. In these cases, typically, the box coater serves the purpose of applying onto the substrates multilayer antireflection (AR) coatings, absorbing color coatings, mirror coatings and/or decorative coatings, possibly combined with screen printing and pad printing steps that are becoming a trend recently in the coating of eyeglasses and frames, for - usually tampography - printing a logo or geometries to be shown on the product, as well. Another possible field of application are night-vision visors with special optical filter coatings (band-pass filters, low pass filters, high pass filters, broad band AR, narrow band AR, etc.). The box coater can however also be used for other or further deposition purposes, e.g., for applying functional coatings, such as antistatic layers, antismudge layers, hydrophobic or superhydrophobic layers, anti-fog layers, conductive layers, etc., which generally have in common that a high uniformity level of the respective coating ensures better uniformity in the functional properties.

Box coaters in which the substrate holder arrangement described herein can be used are available, for example, under the commercial series designations "1200" and "1500" from the present applicant, Satisloh AG, Switzerland. The basic structure and functions of such box coater are described in the brochure "An Introduction To The Coating Of Ophthalmic Lenses", 2nd Edition 2006, available from the present applicant, to which explicit reference shall be made at this point.

### PRIOR ART

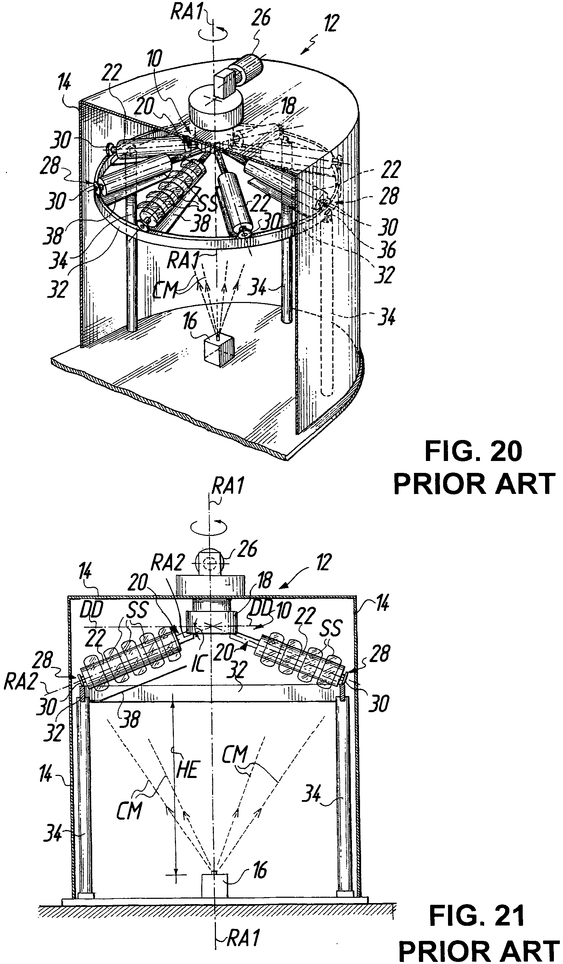

A vacuum coating apparatus comprising a substrate holder arrangement according to the preamble portion of claim 1 is known from document WO 03/083162 A1 and shown in the attached Figs. 20 and 21. Accordingly, in the installed state of the substrate holder arrangement 10 - which basically can be retrofitted in an existing vacuum coating apparatus 12 if desired or needed - the substrate holder arrangement 10 is received in a vacuum chamber 14 of the vacuum coating apparatus 12 opposite and spaced from an evaporation source 16, so that coating material CM evaporated from the evaporation source 16 can impinge on surfaces to be coated of the substrates SS held by the substrate holder arrangement 10. The substrate holder arrangement 10 comprises a hub portion 18 rotatably drivable about a first rotational axis RA1, which can be positioned in a defined manner with respect to the evaporation source 16 in general, a plurality of arm members 20 extending away from the hub portion 18 in a radial direction with respect to the first rotational axis RA1 as seen in a top view, i.e. from above in Fig. 20, and one roller body 22 per arm member 20 which is mounted on the respective arm member 20 so as to be rotatably drivable about a second rotational axis RA2 extending along the respective arm member 20. Each roller body 22 carries a plurality of standardized and fixed fixtures (not shown in detail here) for holding the substrates SS in an orientation in which the main extension direction of the respective substrate SS is substantially transverse to the second rotational axis RA2 (see Fig. 21 in particular).

Further, the known vacuum coating apparatus 12 comprises a first driving device 26, such as for example a conventional motor arranged outside of the vacuum chamber 14, for rotating the hub portion 18 about the first rotational axis RA1 and a second driving device 28 for rotating the roller bodies 22 about the longitudinal axes thereof, i.e. the second rotational axes RA2. Each of the roller bodies 22 is provided with a wheel 30 mounted at a free end thereof and rigidly connected to the respective roller body 22 via a flange. The rotation of the respective wheel 30 about the associated second rotational axis RA2 is guided by a roll bearing arrangement (not illustrated here and conventional *per se*) respectively associated to the roller body 22 and mounted at the arm member 20. The wheel 30 is guided on a circular rail 32 supported by a plurality of vertical supports 34 in the vacuum chamber 14 along a circumferential path surrounding the first rotational axis RA1, so that the second driving device 28 comprises said plurality of wheels 30 and said circular rail 32 that is fixed to the vertical supports 34 via suitable fixing devices 36. When the first driving device 26 rotates the hub portion 18 of the substrate holder arrangement 10, in fact, the wheels 30 are rotated on the circular rail 32 by friction, so that a rotation of the substrate holder arrangement 10 about the first rotational axis RA1 results in a simultaneous rotation of the roller bodies 22 about the longitudinal axes thereof, i.e. the second rotational axes RA2, thus forming a "planetary system" for movably holding the substrates SS vis-à-vis the evaporation source 16.

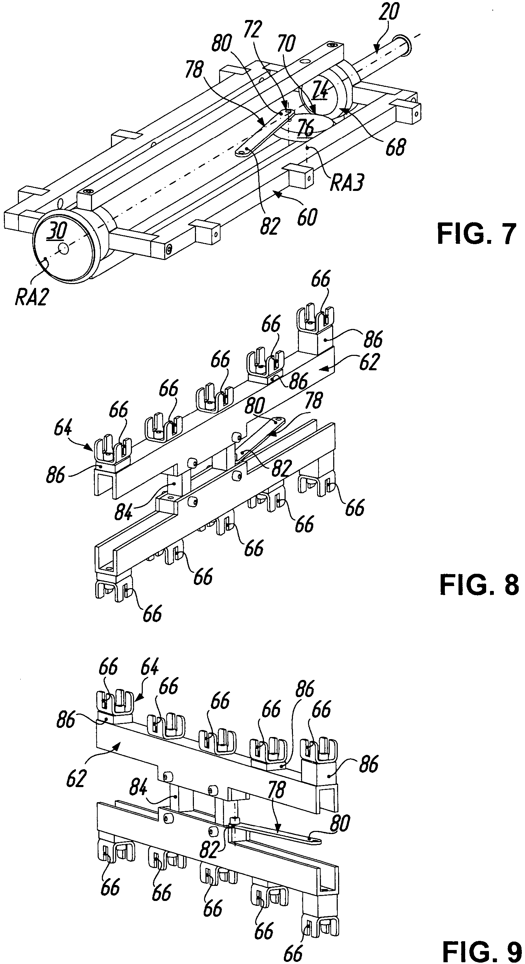

In this prior art, the evaporation source 16 is positioned substantially in alignment with the first rotational axis RA1 of the substrate holder arrangement 10 and each of the roller bodies 22 is inclined towards the evaporation source 16 at an acute angle IC (see Fig. 21) - of approximately 22° in this case - with respect to a transverse direction DD substantially perpendicular to the first rotational axis RA1. By selecting an acute angle IC of suitable value, the uniformity of the coating shall be enhanced because, seen along the respective roller body 22, the distances between the substrates SS held on the roller body 22 and the evaporation source 16 do not vary very much. Further, in Figs. 20 and 21, reference numeral 38 denotes a first screen supported at a predetermined distance from the roller bodies 22 and interposed between the evaporation source 16 and the roller bodies 22. Such first screen 38, in the illustrated embodiment fixed in a conventional manner to the vertical supports 34 at a height HE above the evaporation source 16, is intended to further enhance the uniformity of the thickness of the coating film deposited on the different substrates SS, thus avoiding possible slight coating inhomogeneities which may occur in particular if the vacuum coating apparatus 12 has a small size. Finally, as shown in Fig. 9 of document WO 03/083162 A1 at reference numerals 24, in another embodiment a plurality of second screens each supported at a predetermined distance from the respective roller body and substantially parallel thereto may be provided, so as to partially mask at least a portion of the respective substrate to be coated. Such second screens preferably have a saw-toothed edge adapted to form a shaded coating on the associated substrate supported by the respective roller body.

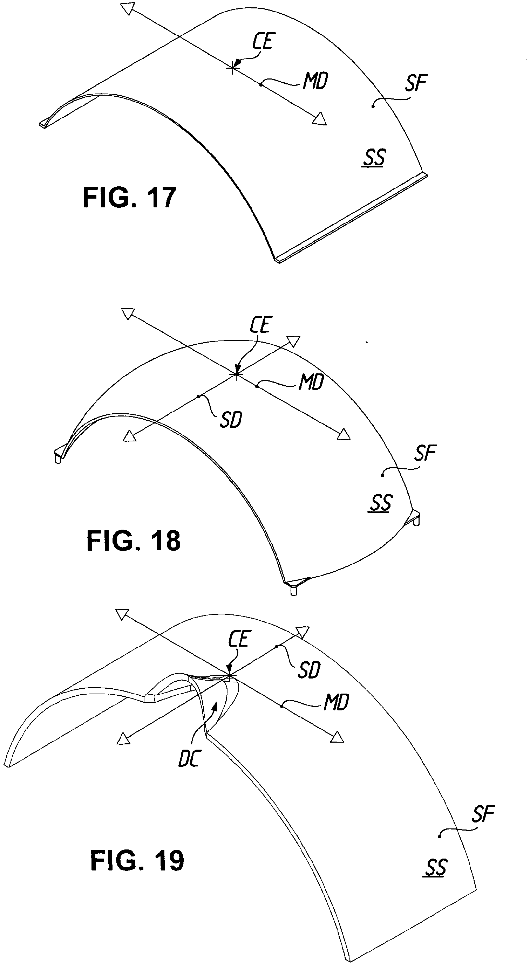

Accordingly, the known planetary system allows to reach a certain level of uniformity of the coating on the substrates SS thanks to a double rotation of the substrates SS with respect to the evaporation source 16: a first rotation around the first rotational axis RA1 that connects the evaporation source 16 to the center of the planetary flange (i.e. the hub portion 18) on the ceiling of the vacuum chamber 14 and a second rotation around the longitudinal axis (i.e. the second rotational axis RA2) of the respective roller body 22 to which the substrates SS are mounted. As explained above, distribution masks (i.e. the first and second screens) can be integrated too in order to further optimize the uniformity, and these masks can be fixed to the vacuum chamber 14 or fixed to the roller bodies 22 (without rotating together with them) depending on the shape of the substrates SS - cylindrical as shown in Fig. 17 vs toroidal as illustrated in Fig. 18 - and depending on the uniformity correction that needs to be achieved.

Currently, the rotation of the substrates SS around the second rotational axis RA2 in particular assures a high level of uniformity on the right to left direction of the substrates SS, i.e. their main extension direction MD as shown in Figs. 17 to 19 for different possible substrates SS, but the uniformity in the up and down directions of the substrates SS, i.e. their secondary extension direction SD transverse to the main extension direction MD, is difficult to achieve especially for toroidal (cf. Fig. 18) or spherical substrates SS either convex or concave, which are more or less curved also along their secondary extension direction SD. This applies all the more to substrates SS which have greater "discontinuities" on the surface SF to be coated in their main and secondary extension directions MD, SD, as for example in the case of the visor shown as a substrate SS in Fig. 19 with a "nose section" as a rather large discontinuity DC of the surface SF to be coated.

Especially in the case of more "complicated" substrate SS geometries, as shown in Figs. 18 and 19 for example, the actual state of the art approach therefore passes through the production of many different fixtures for holding the substrates SS on the roller bodies 22 or through the realization of provisional fixtures, sometimes even using adhesive tape or other quick-to-modify but also unstable "artisanal" solutions by the process engineer in charge, in order to also find the optimum inclination position of the substrates SS relative to the evaporation source 16 on the respective roller body 22 in a trial-and-error phase before the actual production can start. Even if the process engineer has defined the best possible inclination angles for different substrate SS positions relative to the evaporation source 16, it may be possible, after definition of also the best distribution mask(s), that e.g. the color distribution on the coated substrates SS is not yet perfect and needs to be further optimized. This can be the case in particular for substrates SS that deviate from mere cylindrical/toroidal shapes, as shown in Fig. 19.

With a view to achieving the highest possible efficiency in coating the curved substrates, in particular, it would be desirable if finding, in relation to the evaporation source, of the correct orientation and position of the substrates on the roller bodies required for the desired uniformity of the coating could somehow be simplified. It would also be desired if the effort associated with providing additional suitable distribution masks for optimizing the coating uniformity could be avoided, or at least reduced.

### OBJECT

The present invention accordingly has the object, starting from the prior art as outlined above and shown in Figs. 20 to 21 for instance, of creating a substrate holder arrangement for holding substrates curved at least along a main extension direction during a vacuum coating process, that, with an ideally simple structure, addresses the problems described above and which, in particular, helps to achieve the desired uniformity of the coating on the substrates with as little effort as possible, even on substrates with strong and/or multiple curvatures. The object also encompasses the provision of a vacuum coating apparatus comprising such substrate holder arrangement, either already originally or in a retrofitted manner.

### ILLUSTRATION OF THE INVENTION

This object is fulfilled by the features indicated in claim 1. Advantageous or expedient developments of the invention are the subject of claims 2 to 15.

According to the invention - in the case of a substrate holder arrangement for holding substrates curved at least along a main extension direction during a vacuum coating process, which is adapted to be received in a vacuum chamber of a vacuum coating apparatus opposite and spaced from an evaporation source, so that coating material evaporated from the evaporation source can impinge on surfaces to be coated of the substrates held by the substrate holder arrangement, and that comprises: a hub portion rotatably drivable about a first rotational axis, which can be positioned in a defined manner with respect to the evaporation source, at least one arm member extending away from the hub portion in a radial direction with respect to the first rotational axis as seen in a top view, and at least one roller body which is mounted on the arm member so as to be rotatably drivable about a second rotational axis extending along the arm member, wherein the roller body carries at least one fixture for holding the substrate in an orientation in which the main extension direction of the substrate is substantially transverse to the second rotational axis - the fixture for holding the substrate is arranged tiltable relative to the roller body about a tilt axis which runs substantially transversely to the second rotational axis, so that an angle α between a surface normal in a center of the surface to be coated of a substrate held by the fixture and a perpendicular on the second rotational axis passing through the center can be adjusted.

In other words, a basic idea of the invention is to provide, in addition to the known two possibilities of movement of the individual substrates with respect to the evaporation source - namely their rotation about both the first rotational axis and the second rotational axis, which mainly addresses the uniformity of the coating along the main extension direction of the substrates - a defined third possibility of movement for the individual substrates along the secondary extension direction of the substrates, namely the possibility of a defined and clearly reproducible tilting of the substrates about the respective tilt axis that runs transversely to the second rotational axis. This third possibility of movement for the individual substrates serves the purpose of a simplified finding of or achieving a comparative uniformity of the coating also along the secondary extension direction of the substrates.

According to the invention, the following two options are available for individually pivoting the substrates about their tilt axes: Either "static tilting" or "dynamic tilting". In the first alternative of "static tilting" the individual fixture is adapted to be statically fixable with respect to the roller body at a predetermined tilt angle α about the tilt axis, in which the fixture remains during an actual coating process of a substrate held on the fixture. In a very simple case, for example, a simple set screw can be provided on the fixture by which the fixture can be fixed in its respective tilted position relative to the roller body. This "fixed but variable" inclination of the individual fixture is helpful in particular for process development - in this context "fixed but variable" means the inclined position of the fixture (and thus of the substrate held thereon) can be adjusted and then easily fixed in a specific position before the coating process starts; the inclination position of the fixture initially set relative to the second rotational axis of the roller body then does not change during the coating process. The process engineer can thus easily test different inclination positions of the respective substrate in test series, if necessary in combination with a suitable distribution mask, in order to find a coating that is as uniform as possible even in the secondary extension direction of the respective substrate. Once an optimum tilt position has been found for the respective substrate position on the roller body, this can be adopted for the coating of identical substrates for mass production. Flexibility in process design is thus greatly increased because no mechanical parts have to be replaced or temporary solutions used to hold the substrates in different inclination positions for the test series.

In the second alternative, i.e. the "dynamic tilting" approach, the arrangement can be chosen such that the fixture is arranged in a way that it can be tilted dynamically about the tilt axis with respect to the roller body during the rotation of the roller body about the second rotational axis, so that a substrate held on the fixture can be rotated about the second rotational axis and tilted in an oscillating manner about the tilt axis at the same time during the actual coating process. This "real variable" inclination of the individual fixture opens up an additional dimension and complexity in process design: By dynamically tilting the substrate along its respective secondary extension direction, the uniformity of the coating in this direction can be addressed directly with a view to increasing productivity. Such a tilting capability of the substrate may even help to eliminate the need for any distribution masks for the uniformization of the coating along the substrate's secondary extension direction - and of course the effort associated with the correct shaping and positioning of such distribution masks. This should also save process time and consumables because finally the target, i.e. the respective substrate is coated, and not the formerly assigned distribution mask. Providing the possibility of an additional dynamic back and forth movement of the substrates about the assigned tilt axes, i.e. along their respective secondary extension direction during the coating thus basically opens the chance to fine-tune such movements in such a way that during one revolution of the respective substrate around the second rotational axis all points to be coated of the substrate occupy the same distance relative to the evaporation source for the same period of time, which makes the resulting coating uniform. Such fine-tuning can then be done in a simple manner by suitably adjusting the mechanical elements that generate the reciprocating motion of the substrates. Such a "dynamic tilting" approach would be particularly beneficial for substrates that are strongly curved along their secondary extension direction and/or substrates that are curved in different directions (cf. Fig. 18) or exhibit discontinuities on the surface to be coated (cf. Fig. 19) .

As to the claimed defined position of the first rotational axis of the substrate holder arrangement with respect to the evaporation source it remains to be noted that it may be such that the first rotational axis is aligned with the evaporation source in a preferred simple design, so that the first rotational axis intersects the evaporation source. Depending on the coating process and equipment used, however, the first rotational axis can also be located laterally offset with respect to the evaporation source(s). Such "off axis evaporation sources" may be present, for example, when evaporating from lateral thermal (resistive) sources or in the case of box coaters using two off axis EBG (electron beam gun) sources.

Particularly with regard to a lightweight construction of the mechanism for providing the aforementioned third movement possibility for the individual substrates, which can be realized as simply and inexpensively as possible in terms of design, it is preferred if the at least one fixture is mechanically positively forcibly guided with respect to the roller body via a hinge mechanism so as to be pivotable with respect to the tilt axis. In one specific embodiment of such an articulated mechanism, the hinge mechanism may comprise at least one sliding joint which has, between the fixture and the roller body, a coulisse carrier with at least one coulisse slot which is curved in an arc of a circle about the tilt axis and in which a guide portion is accommodated so as to be slidable but nonetheless non-rotatable with respect to the coulisse slot (non-fulcrumed mechanism). Such mechanism does not require tight tolerances and is easy to assemble and regulate. Depending on the substrate geometry in particular or the respective coating requirements, however, the sliding joint can also be designed differently, for example with a straight or S-shaped curved coulisse slot in which the guide portion is accommodated so that it can slide and in fact rotate with respect to the coulisse slot (fulcrumed mechanism). In such a case, the tilt axis may actually also shift along the roller body when the fixture pivots about the tilt axis.

In the case of the aforementioned non-fulcrumed mechanism, where the guide portion is non-rotatably received in the associated coulisse slot, the guide portion may be formed by two laterally spaced-apart coulisse pins which permit a positively guided displacement of the guide portion in the coulisse slot, but nevertheless prevent a rotation of the guide portion in the coulisse slot. Thus, the guide portion not only has a particularly simple design, but can also move with particularly low friction in the associated coulisse slot, with the coulisse pins in each case only resting linearly on the associated coulisse slot. Of course, other designs of the guide portion are also conceivable, e.g. as a simple molded body with a cross section that prevents rotation in the coulisse slot, or with more than two coulisse pins per sliding joint.

In principle, it is possible for the guide portion to be attached to the roller body, while the coulisse carrier with the associated coulisse slot is provided on the fixture. However, with regard to the simplest possible design and a low installation space requirement, it is preferred if the coulisse carrier with the coulisse slot is attached to the roller body, while the guide portion is provided on the fixture.

Further, especially with regard to high smoothness when pivoting an arrangement of the hinge mechanism is preferred in which the fixture has opposite longitudinal ends, as viewed in a direction transverse to the second rotational axis, at each of which a sliding joint is provided. However, it is also conceivable - but less preferred - that a sliding joint is provided on the fixture only at one longitudinal end thereof in the sense of a flying bearing arrangement.

In order to simplify the conducting of the above-mentioned coating tests and for a better control of the process, it is preferably provided - but does not have to be - that a scale is attached to the sliding joint, on which the angle α can be read by which the fixture is tilted about the tilt axis with respect to the roller body.

Furthermore, as far as a preferred tilt angle α is concerned, the sliding joint can be designed to allow a tilting of the fixture with respect to the roller body from -20 degrees to +20 degrees about the tilt axis, wherein the angular position of 0 degrees for the fixture is selected such that, when the fixture faces the evaporation source, the surface normal at the center of the surface to be coated of a substrate held on the fixture points substantially to a point on the evaporation source. Thus, a dynamic tilting of the substrates results in an equal coating of the substrates on both sides of the surface normal along the secondary extension direction of the respective substrate. In coating tests carried out by the applicant with generic sports visors as substrates, a pivoting range of -20 degrees to +20 degrees has proven to be sufficient and advantageous, but depending on the respective substrate geometry, in particular the substrate curvature(s), and the parameters of the respective coating process, the permitted pivoting range for the substrates can of course also be smaller or larger, e.g. from -35 degrees to +35 degrees or the like.

In a preferred specific embodiment of the roller body, it may further be provided that the roller body has a base frame which is mounted on the arm member such that it can rotate about the second rotational axis and on which a carriage is guided such that it can be displaced longitudinally along the second rotational axis, the coulisse carrier of the at least one sliding joint being mounted on the base frame, while an entraining mechanism is arranged between the carriage and the fixture, the entraining mechanism being adapted to tilt the fixture in the sliding joint about the tilt axis in the event of a longitudinal displacement of the carriage with respect to the base frame. Such a design of the roller body is particularly advantageous with regard to a small number of required components and the ease of actuation if several fixtures are mounted on the roller body, which are to be pivoted simultaneously about their respective pivot axis as easily as possible.

In this case, preferably, the entraining mechanism between the carriage and the fixture may have a fork joint via which the fixture can be driven to tilt about the tilt axis. Such design for the entraining mechanism is considered to be the easiest and cheapest solution, with not so tight tolerances and with an easy assembly procedure. A fork of the fork joint pushing a pin of the fork joint provided on the related fixture without tying it up, but leaving the pin free to move up and down in the fork slot, advantageously allows to easily modify fixture movements - and thus substrate movements - by merely changing the shape of the associated coulisse slot(s) in the coulisse carrier(s) of the above-mentioned sliding joint(s) without any other changes. Accordingly, such modification would be easy and quick to realize for any new substrate geometry to be coated.

In principle, it is conceivable to provide a separate swivel drive for generating the tilting movement of the respective fixture about its tilt axis on the roller body, in particular for the above-discussed "dynamic tilting" approach, e.g. in the form of a suitably drive-connected electric motor or a suitably articulated piston-cylinder arrangement. However, particularly with regard to the simplest possible design and ease of use and maintenance, it is preferred if provision is made for a gear mechanism for forced coupling of the rotational movement of the roller body about the second rotational axis and the tilting movement of the fixture about the tilt axis. For example, in the case of the above-described structure of the roller body with a base frame and a carriage guided thereon, the gear mechanism for forced coupling of the rotational movement of the roller body about the second rotational axis and the tilting movement of the fixture about the tilt axis may be adapted to convert the rotational movement of the roller body into an oscillating longitudinal movement of the carriage on the base frame of the roller body.

In one embodiment, the gear mechanism for forced coupling of the rotational movement of the roller body about the second rotational axis and the tilting movement of the fixture about the tilt axis may comprise a bevel gear pairing and an eccentric drive, the bevel gear pairing having a first bevel gear which is mounted fixedly in terms of rotation on the arm member and meshes with a second bevel gear which is mounted on the base frame of the roller body so as to be rotatable about a third rotational axis which runs perpendicularly to the second rotational axis, and to which a push rod of the eccentric drive is articulated eccentrically with respect to the third rotational axis by one end, the other end of the push rod being articulated to the carriage of the roller body. Such a transmission design is not only cost-effective, but also robust in operation. However, other gear types and configurations are also conceivable for the person skilled in the art in order to ultimately convert the rotational movement of the roller body, which is given anyway, into a tilting oscillatory movement of the respective fixture for the substrate.

Furthermore, as far as numerical movement dependencies and ratios are concerned in this context, it may be preferably provided that a transmission ratio of the gear mechanism for forced coupling of the rotational movement of the roller body about the second rotational axis and the tilting movement of the fixture about the tilt axis is selected in such a way that the fixture swivels back and forth about the tilt axis with a frequency that is not an integer number and lies between 0.5 and 2.5 per revolution of the roller body about the second rotational axis. When integrating such a gear concept with the proposed substrate holder arrangement into the known drive concept according to Figs. 20 and 21, in which there is a primary rotation of the substrate holder arrangement about the first rotational axis and a secondary rotation of the respective roller body about the second rotational axis coupled therewith, the following ratios and numbers can thus result: The rotation frequency ratio between the secondary rotation and the primary rotation conventionally is between 20 and 21 for example. A typical primary rotation speed would be, e.g., 10 RPM - within a possible range of 5 to 50 RPM for the primary rotation speed - bringing the secondary rotation in the 200 RPM range for instance. Considering then to have the tertiary oscillation movement about the respective tilt axis at the fixture with a frequency ratio between 0.5 and 2.5 with respect to the secondary rotation, as indicated above, so a substrate oscillation frequency in the 100 times/min to 500 times/min range would result. Finally, regarding the topic of "ratio selection" an important point is that the transmission ratio between secondary and tertiary movements - but also between primary and secondary rotations - shall not be an integer number but should be ideally an irrational number or in any case such that the time needed for the arrangement to return in the same exact position is longer than the duration of the deposition step.

Depending on the size and/or curvature of the substrates to be coated, it is of course conceivable that only one fixture is provided on the roller body or that several fixtures are provided at an equal angular distance from each other around the second rotational axis to three or four sides of the roller body. However, particularly with regard to a high utilization rate when coating substrates in mass production and/or a favorable weight distribution for a very uniform rotation of the roller body about the second rotational axis, it is preferred if provision is made for a plurality of fixtures arranged mirror-symmetrically on the roller body with respect to a plane containing the second rotational axis.

In such a case it is preferred if each of the fixtures is associated with a fork joint of the entrainment mechanism, each fork joint being attached to the carriage of the roller body for a common movement with respect to the base frame of the roller body. In principle, it would also be possible to drive the individual entrainment mechanisms for the several fixtures separately, but this would require more technical effort, more parts and correspondingly larger moving masses, which is why such an embodiment is less preferred.

In such an embodiment, it is further preferred, with a view to a very uniform application of the coating material without the need to use intricately shaped distribution masks, that the fixtures are arranged on the roller body with the aid of spacers, while the coulisse slots of the sliding joints are arranged at different heights of the coulisse carrier, so that, in a state of the substrate holder arrangement installed in the vacuum chamber of a vacuum coating apparatus, when the fixtures provided on one side of the second rotational axis face the evaporation source in the vacuum chamber, the tilt axes of the fixtures lie on a circular arc in the center of which the evaporation source is located. However, depending in particular on the size and/or the shape of the substrates to be coated and/or the size of the vacuum coating apparatus in which the proposed substrate holder arrangement is to be accommodated, it is of course also conceivable for the tilt axes of the individual fixtures to lie on a curve other than an arc or on a straight line when they are facing the evaporation source.

Finally, a vacuum coating apparatus is proposed as well that comprises a vacuum chamber, in which an evaporation source is arranged, wherein a substrate holder arrangement as discussed above is received in the vacuum chamber opposite and spaced from the evaporation source - either already from the outset or in a retrofitted manner - so that coating material evaporated from the evaporation source can impinge on surfaces to be coated of the substrates held by the substrate holder arrangement.

### BRIEF DESCRIPTION OF THE DRAWINGS

The invention is explained in more detail in the following by way of preferred embodiments of a substrate holder arrangement in a vacuum coating apparatus for vacuum coating of curved substrates such as visors with reference to the accompanying, partly simplified or schematic drawings. For simplification of the illustration, apart from parts of the cladding and door of the vacuum coating apparatus, the electron beam gun with shutter, the operating unit and control system (electrical cabinet), screens, handling devices and deposits for the substrates and consumables, the supply and conditioning devices - inclusive of lines, hoses and pipes - for current (transformers), compressed air, vacuum (high vacuum pump set) and cooling water (water thermo conditioner, water chiller) as well as the measuring, maintenance and safety devices, in particular, were also omitted from the drawings, in every instance to the extent that they are not required for the understanding of the invention. The above-mentioned omitted parts, assemblies and devices, in structure and function, are known to the person skilled in the art anyway. In the drawings:

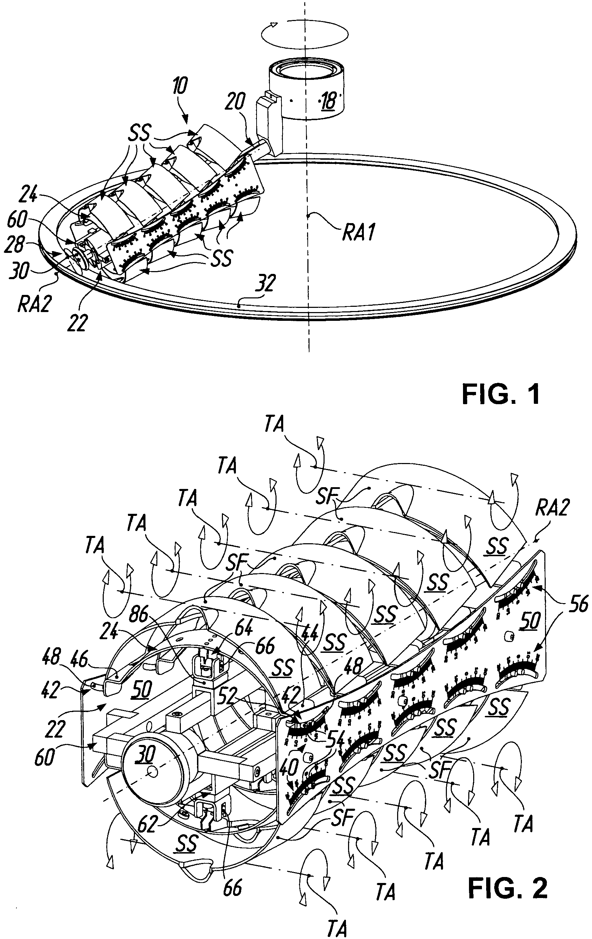

- Fig. 1: shows a perspective view of a substrate holder arrangement for a vacuum coating apparatus according to a first embodiment of the invention obliquely from above and isolated from the vacuum coating apparatus, which substantially comprises a central hub portion arranged rotatable about a first rotational axis, a plurality of arm members extending essentially radially away from the hub portion, of which only one arm member is shown to simplify the drawing, and plurality of roller bodies assigned to the arm members and arranged rotatable about a respective second rotational axis extending along the associated arm member, of which, again, only one roller body is shown for a better illustration of the structure thereof, wherein the roller body carries a plurality of fixtures for holding curved substrates in a manner dynamically pivotable relative to the roller body about tilt axes running substantially transversely to the respective second rotational axis;
- Fig. 2: shows an enlarged perspective view of the roller body of the substrate holder arrangement according to Fig. 1 isolated from the substrate holder arrangement for a better illustration of its structure;

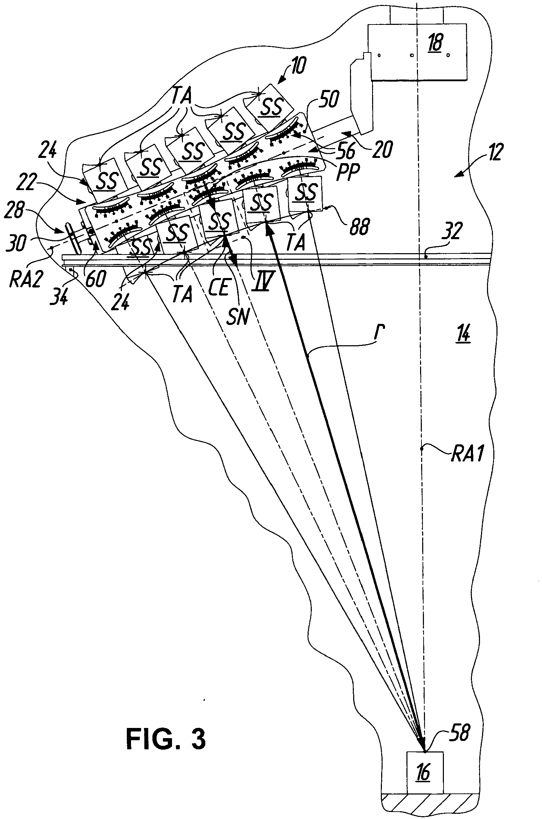

- Fig. 3: shows a cut-out front view of the substrate holder arrangement according to Fig. 1 mounted in a vacuum chamber of the vacuum coating apparatus, in order to, in particular, illustrate the relative position of the substrate holder arrangement with respect to an evaporation source also located in the vacuum chamber;

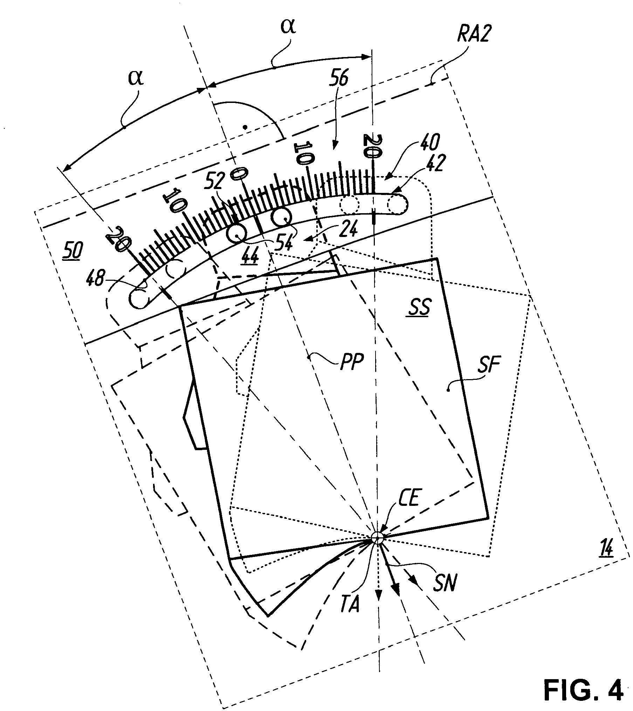

- Fig. 4: shows an enlarged view of the detail IV in Fig. 3, to illustrate the tilting capability of one of the fixtures of the roller body about its tilt axis, wherein the dotted, bold, and dashed lines indicate different tilt positions of the fixture and the assigned substrate held thereon;

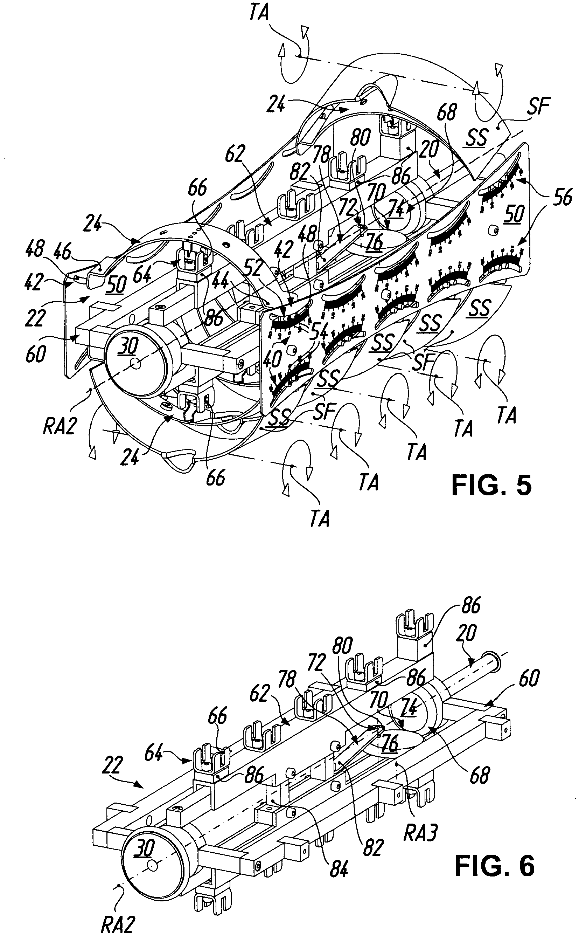

- Fig. 5: shows an enlarged perspective view of the roller body of the substrate holder arrangement according to Fig. 1 isolated from the substrate holder arrangement, with a viewing angle corresponding to Fig. 2, wherein, in contrast to Fig. 2, the fixtures and substrates on the upper side of the roller body have been partially omitted in order to provide a view of the underlying assemblies and parts of the roller body;
- Fig. 6: shows a perspective view of the roller body according to Fig. 2, with a viewing angle corresponding to Fig. 5, wherein all fixtures and substrates as well as two lateral coulisse carriers as parts of sliding joints assigned to the fixtures have been omitted for illustration purposes;
- Fig. 7: shows, again with a viewing angle corresponding to Fig. 5, an isolated perspective view of a base frame of the roller body according to Fig. 2 and of an assigned gear mechanism for forced coupling of the rotational movement of the roller body about its second rotational axis and a common tilting movement of the associated fixtures about their tilt axes;
- Fig. 8: shows, still with a viewing angle corresponding to Fig. 5, an isolated perspective view of a carriage of the roller body according to Fig. 2, that, in its installed state, is guided for longitudinal displacement along the second rotational axis of the roller body on the base frame shown in Fig. 7, with a push rod of the gear mechanism according to Fig. 7 articulated on the carriage for driving the carriage;
- Fig. 9: shows an isolated perspective view of the carriage and push rod assembly according to Fig. 8, in contrast to Fig. 8, however, from a different direction, more precisely from diagonally behind in Fig. 8;

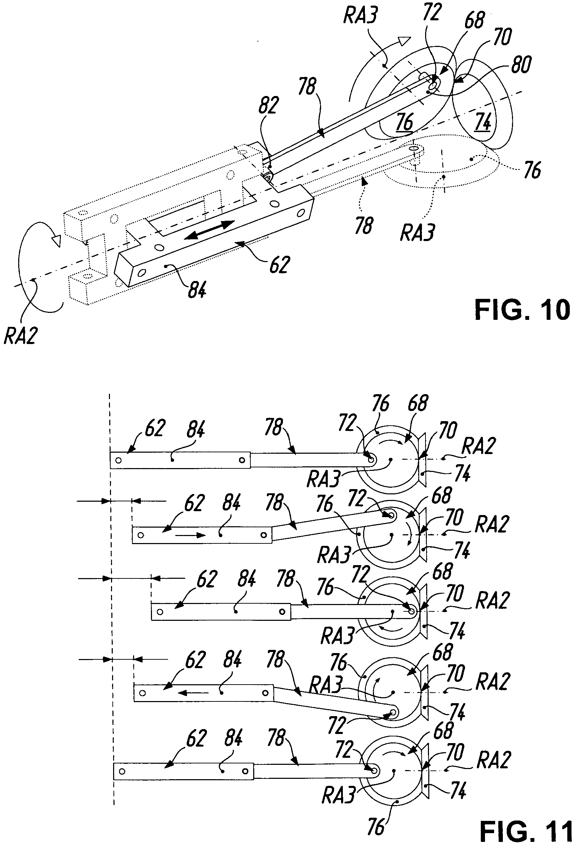

- Fig. 10: illustrates in a schematic perspective view how, by the gear mechanism shown in Fig. 7, an oscillating back and forth movement of the carriage according to Figs. 8 and 9 is forced along the second rotational axis during a rotation of the roller body according to Fig. 2 about the second rotational axis;
- Fig. 11: also illustrates, by schematic side views, how the gear mechanism shown in Fig. 7 forces the oscillating back and forth movement of the carriage according to Figs. 8 and 9 along the second rotational axis during one revolution of the roller body according to Fig. 2 about the second rotational axis, wherein it can also be clearly seen here which paths the carriage covers in the course of this longitudinal movement for one revolution of the roller body;

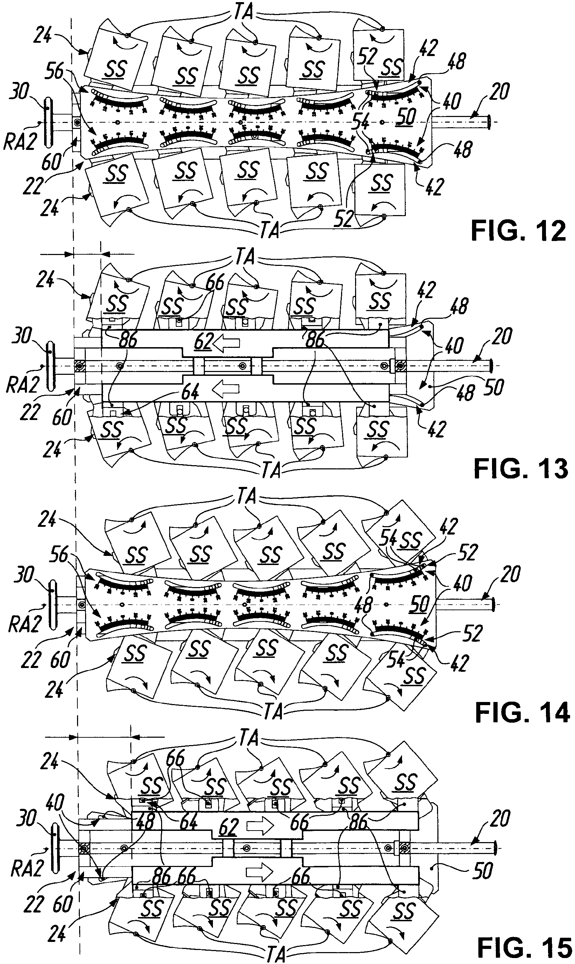

- Figs. 12: to 15 show partially broken-up side views of the roller body according to Fig. 2 in different rotational positions about the second rotational axis, illustrating how the individual fixtures are driven together via in each case a fork joint of an entrainment mechanism between the carriage of the roller body and the fixtures and, as a result of their mechanically positive guidance in sliding joints of a hinge mechanism between the roller body and the fixtures, that comprise coulisse pins in coulisse slots, are dynamically pivoted about their respective tilt axes together with the held substrates;

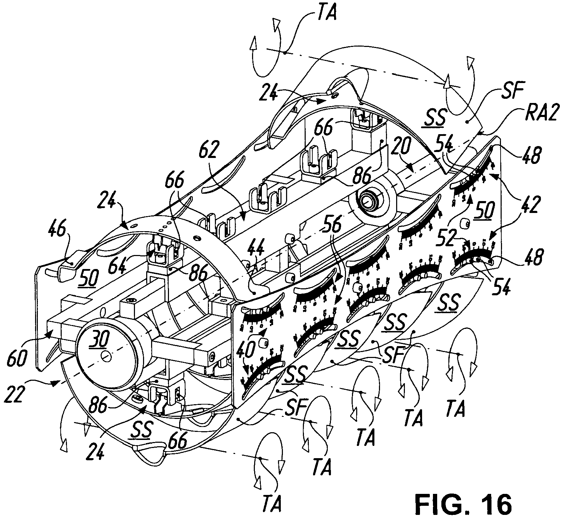

- Fig. 16: shows a perspective view of a roller body isolated from a substrate holder arrangement for a vacuum coating apparatus according to a second embodiment of the invention obliquely from above, which differs from the first embodiment illustrated in Figs. 1 to 15 mainly in that the individual fixtures on the roller body can be adjusted about their tilts axes in a static manner only, but not tilted dynamically about the tilt axes, wherein, similar to Fig. 5, the fixtures and substrates on the upper side of the roller body have been partially omitted in order to provide a view of the underlying assemblies and parts of the roller body;
- Figs. 17: to 19 show perspective views of various visors with different geometries as substrate examples that can be held on the substrate holder arrangement according to the present invention for coating purposes;
- Fig. 20: shows, obliquely from above and front right, a perspective view of a known vacuum coating apparatus in a rather schematic way of representation, that comprises a conventional substrate holder arrangement which is configured as described in great detail in document WO 03/083162 A1; and
- Fig. 21: shows a front view of the known vacuum coating apparatus according to Fig. 20, wherein in particular a stationary distribution mask (first screen) for unifying or equalizing the coating on the various substrates on the roller bodies can be seen below the substrate holder arrangement in the vacuum chamber.

### DETAILED DESCRIPTION OF THE PREFERRED EMBODIMENTS

A substrate holder arrangement for holding, during a vacuum coating process, substrates SS that are curved at least along a main extension direction MD - such as the visors shown in Figs. 17 to 19 as possible substrates SS - is generally denoted by the reference number 10 in Figs. 1 and 3. As illustrated in Fig. 3 in particular, which shows a section of a vacuum coating apparatus 12 only, the substrate holder arrangement 10 is adapted to be received in a vacuum chamber 14 of the vacuum coating apparatus 12 opposite and spaced from an evaporation source 16, so that coating material evaporated from the evaporation source 16 can impinge on surfaces SF (cf. Fig. 2) to be coated of the substrates SS held by the substrate holder arrangement 10. As can be seen in Figs. 1 and 3, basic components of the substrate holder arrangement 10 are a central hub portion 18, a plurality of arm members 20 attached to the hub portion 18, and a plurality of roller bodies 22, each assigned to one arm member 20.

The hub portion 18 of the substrate holder arrangement 10 is rotatably drivable about a first rotational axis RA1 - as is known *per se* (see the first driving device 26 in Figs. 20 and 21 for the prior art substrate holder arrangement 10) and therefore not shown in more detail in Figs. 1 and 3 - which can be positioned in a defined manner with respect to the evaporation source 16. In the illustrated embodiment, this spatial arrangement is such that the hub portion 18 is aligned with the evaporation source 16 along the first rotational axis RA1.

As seen in a top view, the arm members 20 actually extend away in a radial direction from the hub portion 18 in a star-shaped arrangement with equal angular distances from each other with respect to the first rotational axis RA1. To simplify the illustration and for the sake of clarity, only one arm member 20 is shown in Figs. 1 and 3.

The roller body 22 assigned to the respective arm member 20 is mounted on the arm member 20 so as to be rotatably drivable about a second rotational axis RA2 extending along the arm member 20. The rotatable mounting of the roller body 22 on the associated arm member 20 as well as the rotational drive of the roller body 22 about the second rotational axis RA2 with the aid of a friction wheel drive, consisting of a wheel 30 mounted on the respective roller body 22 in a rotationally fixed manner, which rolls on an associated circular rail 32 mounted in a stationary manner in the vacuum chamber 14 of the vacuum coating apparatus 12, is also known *per se* (see again Figs. 20 and 21) and will therefore not be described in more detail here. As a result, a rotation of the hub portion 18 about the first rotational axis RA1 causes a rotational entrainment of the arm members 20 and thus a relative movement of the respective roller bodies 22 rotatably supported on the arm members 20 with respect to the circular rail 32, which in turn leads to a rotation of the respective roller body 22 about the second rotational axis RA2 due to the frictional connection between the wheel 30 attached to the end of the roller body 22 and the circular rail 32 in the vacuum chamber 14. The two rotational movements of the respective roller body 22 about the first rotational axis RA1 and the second rotational axis RA2 are therefore positively coupled.

As can be seen best in Figs. 2 and 5, each roller body 22 carries a plurality of fixtures 24 for holding a respective substrate SS in an orientation in which the main extension direction MD of the substrate SS is substantially transverse to the second rotational axis RA2. In the embodiment shown, the fixtures 24 are arranged mirror-symmetrically on the roller body 22 with respect to a plane containing the second rotational axis RA2. More precisely, on each side of this plane, five fixtures 24 are arranged one behind the other as seen along the second rotational axis RA2 in this example, so that one roller body 22 can accommodate ten substrates SS, as illustrated in Figs. 1 to 3.

Further, as will be explained in more detail below, according to an important feature of the newly disclosed substrate holder arrangement 10 over the previously known design, the respective fixture 24 for holding the substrate SS is arranged tiltable relative to the roller body 22 about an assigned tilt axis TA which runs substantially transversely to the second rotational axis RA2, as shown in Fig. 2 for example. As a result of this arrangement, as illustrated in Figs. 3 and 4, an angle α between a surface normal SN in a center CE of the surface SF to be coated of a substrate SS held by the fixture 24 and a perpendicular PP on the second rotational axis RA2 passing through this center CE can be adjusted, either dynamically for the first embodiment of the substrate holder arrangement 10 according to Figs. 1 to 15 or statically for the second embodiment of the substrate holder arrangement 10 illustrated in Fig. 16.

For example, the substrate SS drawn with a dotted line in Fig. 4 is tilted about the associated tilt axis TA by an angle α of +20 degrees relative to the perpendicular PP, while the substrate SS drawn with a dashed line in Fig. 4 is tilted about the tilt axis TA by an angle α of -20 degrees relative to the perpendicular PP. For the substrate SS drawn with a bold line in Fig. 4, the tilt angle α about the tilt axis TA is 0 degrees, so that the surface normal SN on the substrate SS is aligned with the perpendicular PP. Accordingly, depending on the allowed range for the tilt angle α, each point on the surface SF of a single substrate SS to be coated can be tilted about the tilt axis TA for a certain rotational position of the roller body 22 about the second rotational axis RA2 in such a way that it has the same distance r (see Fig. 3) from the evaporation source 16. This circumstance can be used by suitable adjustment or control of the tilting of the respective fixture 24 about the tilt axis TA, for example, to deposit the same or at least approximately the same amount of coating material at each point of the surface SF of a substrate SS to be coated in order to increase the uniformity of the entire coating, as already discussed at the beginning.

In the illustrated embodiments, so as to be pivotable with respect to the associated tilt axis TA, the respective fixture 24 is mechanically positively forcibly guided with respect to the roller body 22 via an assigned hinge mechanism 40 that will be explained in the following with reference to Figs. 2, 4, 5 and 12 to 16 in particular. The hinge mechanism 40 comprises at least one sliding joint 42 per fixture 24, more precisely, in the embodiment shown, the respective fixture 24 has two opposite longitudinal ends 44, 46, as viewed in a direction transverse to the second rotational axis RA2, at each of which one sliding joint 42 is provided (see Figs. 2 and 5 in particular). Each sliding joint 42 comprises, between the fixture 24 and the roller body 22, a coulisse slot 48 that is formed in a coulisse carrier 50 attached to the roller body 22 in this example - see, e.g., the coulisse carriers 50 bolted to the roller body 22 to the left and right of the roller body 22 in Figs. 2, 5 and 16. As can be seen best in Fig. 4, the respective coulisse slot 48 is curved in an arc of a circle about the associated tilt axis TA. Each sliding joint 42 further has a guide portion 52 provided on the fixture 24 that is accommodated in the coulisse slot 48 so as to be slidable but nonetheless non-rotatable with respect to the coulisse slot 48 in this case. In the embodiments shown, the respective guide portion 52 is formed by two laterally spaced-apart coulisse pins 54 in a particularly simple configuration, which permit a positively guided displacement of the guide portion 52 in the associated coulisse slot 48, but nevertheless prevent a rotation of the guide portion 52 in the coulisse slot 48.

As is clearly evident from all the figures that show the coulisse carrier 50, a scale 56 is provided at each sliding joint 42, on which the angle α can be read by which the associated fixture 24 is tilted about the tilt axis TA with respect to the roller body 22. This is particularly useful for process engineers when conducting tests to find the optimum position of the substrates SS on the roller body 22 for a particularly uniform coating in case of the static tilting option.

In the illustrated examples, the respective sliding joint 42 is designed to allow a tilting of the associated fixture 24 with respect to the roller body 22 by an angle α from -20 degrees to +20 degrees about the tilt axis TA, as can best be seen in Fig. 4, wherein the angular position of 0 degrees for the fixture 24 is preferably selected such that, when the fixture 24 faces the evaporation source 16 of the vacuum coating apparatus 12, the surface normal SN at the center CE of the surface SF to be coated of a substrate SS held on the fixture 24 points substantially to a point 58 on the evaporation source 16 (cf. Fig. 3), for example the point 58 where the first rotational axis RA1 intersects the evaporation source 16 in this case. In accordance with the respective coating requirements, which depend in particular on the size and shape of the substrates SS to be coated and the respective coating processes or systems to be applied, other, i.e. smaller or larger, angular ranges can of course also be provided for the tilting angle α.

Insofar it is evident that the individual fixtures 24 and thus the substrates SS held thereon can each be forcibly pivoted with respect to the roller body 22 about an associated tilt axis TA that is located in the vicinity of the respective substrate SS or intersects the latter. In this context, it remains to be mentioned that the individual substrates SS are attached to the associated fixtures 24 in a manner known *per se,* e.g. with the aid of a combination of projections attached to the respective fixture 24, which form clearly defined support points for the substrate SS, and clamps for fixing the respective substrate SS in place. Since these measures are known to those skilled in the art, they are not specifically shown in the figures and require no further explanation here.

As previously indicated, in the first embodiment the respective fixture 24 is arranged such that it can be tilted dynamically about the associated tilt axis TA with respect to the roller body 22 during the rotation of the roller body 22 about the second rotational axis RA2, so that a substrate SS held on this fixture 24 can be rotated about the second rotational axis RA2 and tilted in an oscillating manner about the tilt axis TA at the same time during the actual coating process. A possible movement mechanism on the roller body 22 belonging to this dynamic concept in particular will be described below mainly on the basis of Figs. 5 to 15.

First of all, as can best be seen in Fig. 6 to 9, the roller body 22 has a base frame 60 which may be bolted together from multiple metal hub and rod sections, as shown in particular in Fig. 7. According to Fig. 5 for instance, this base frame 60 also serves as a support for the two coulisse carriers 50 of the sliding joints 42 and the wheel 30 of the second driving device 28 (cf. also Figs. 1 and 3). As illustrated in Figs. 6 and 7 for example, the base frame 60 is mounted on the arm member 20 such that it can rotate about the second rotational axis RA2 in a manner known *per se.*

On the base frame 60 a carriage 62 is guided such that it can be shifted longitudinally along the second rotational axis RA2. While the coulisse carriers 50 are mounted on the sides of the base frame 60 with the aid of fixing screws shown in Figs. 2, 5 and 16, an entraining mechanism 64 is arranged between the carriage 62 and the respective fixture 24. This entraining mechanism 64 is adapted to tilt the respective fixture 24 in the associated sliding joint 42 about the tilt axis TA in the event of a longitudinal displacement of the carriage 62 with respect to the base frame 60. To be more precise, the entraining mechanism 64 between the carriage 62 and the respective fixture 24 has a fork joint 66 per fixture 24 via which the assigned fixture 24 can be driven to tilt about the associated tilt axis TA. Since each fork joint 66 is attached to the carriage 62 of the roller body 22 for a common movement with respect to the base frame 60 of the roller body 22 (cf. Figs. 6, 8 and 9), and due to the fork joints 66 being operatively connected to the fixtures 24, a relative longitudinal displacement of the carriage 62 with respect to the base frame 60 allows all fixtures 24 to be tilted about their pivot axes TA, as can be seen in particular in Figs. 13 and 15.

As for a dynamic drive possibility of the carriage 62 on the base frame 60 of the roller body 22, a gear mechanism 68 is provided in the first embodiment according to Figs. 1 to 15 for forced coupling of the rotational movement of the roller body 22 about the second rotational axis RA2 and the tilting movement of the fixture 24 about the tilt axis TA. This gear mechanism 68 is adapted to convert the rotational movement of the roller body 22 about the second rotational axis RA2 into an oscillating longitudinal movement of the carriage 62 on the base frame 60 of the roller body 22 along the second rotational axis RA2.

To be more precise, the gear mechanism 68 has a bevel gear pairing 70 and an eccentric drive 72. As can be seen best in Figs. 5 and 6, the bevel gear pairing 70 comprises a first bevel gear 74 which is mounted fixedly in terms of rotation on the arm member 20 and meshes with a second bevel gear 76 which is mounted on the base frame 60 of the roller body 22 so as to be rotatable about a third rotational axis RA3 which runs perpendicularly to the second rotational axis RA2. Further, the eccentric drive 72 comprises a push rod 78 which is articulated to the second bevel gear 76 eccentrically with respect to the third rotational axis RA3 by one end 80, whereas the other end 82 of the push rod 78 is articulated to the carriage 62 of the roller body 22.

In the embodiment shown, for example, a transmission ratio of the gear mechanism 68 may be selected in such a way that the fixture 24 swivels back and forth about the tilt axis TA with a frequency that is not an integer number and lies between 0.5 and 2.5 per revolution of the roller body 22 about the second rotational axis RA2. In this context, Fig. 10 illustrates how, when the roller body 22 rotates about the second rotational axis RA2, the gear mechanism 68 itself rotates on the first bevel gear 74 - that is fixed against rotation on the arm member 20 - about the second rotational axis RA2, thereby oscillating the carriage 62 of the roller body 22, of which only a base 84 is shown here, back and forth along the second rotational axis RA2 (as indicated by the double arrow in Fig. 10). For this oscillating movement of the carriage 62, Fig. 11 also shows the paths covered by the carriage 62. Accordingly, the fork joints 66 are moved back and forth together with the carriage 62, taking the fixtures 24 engaged therewith with them and tilting the fixtures 24 in their sliding joints 42 about the tilt axes TA. The resulting swivel movements of the substrates SS held on the fixtures 24 are illustrated in Figs. 12 to 15.

Finally, as can still be seen in particular in Figs. 5, 6, 8 and 9, the radially inner and outer most fixtures 24 and fork joints 66 are arranged on the roller body 22, more precisely on the carriage 62 thereof, with the aid of spacers 86 in this embodiment, while, according to Figs. 3, 12 and 14, the coulisse slots 48 of the sliding joints 42 are arranged at different heights of the coulisse carriers 50 - as measured transversely to the second rotational axis RA2 along the respective coulisse carrier 50 - so that, in a state of the substrate holder arrangement 10 installed in the vacuum chamber 14 of the vacuum coating apparatus 12, when the fixtures 24 provided on one side of the second rotational axis RA2 at the roller body 22 face the evaporation source 16 in the vacuum chamber 14, as shown in Fig. 3, the tilt axes TA of the fixtures 24 lie on a circular arc 88 in the center of which the evaporation source 16 is located. This measure also serves to achieve a coating that is as uniform as possible across the various substrates SS in this embodiment.

In the second embodiment according to Fig. 16, the fixtures 24 are (merely) adapted to be statically fixable with respect to the roller body 22 at a predetermined tilt angle α about the associated tilt axis TA, in which the respective fixture 24 remains during an actual coating process of a substrate SS held on the fixture 24. Such a configuration of the substrate holder arrangement 10 can easily be achieved, starting from the construction according to the above-described first embodiment, by omitting the prescribed gear mechanism 68 on the roller body 22 altogether, as shown in Fig. 16. It is then only necessary to suitably ensure that the carriage 62 can be fixed with respect to the base frame 60 of the roller body 22, as seen along the second rotational axis RA2, when the desired tilting of the fixtures 24 about their respective tilt axis TA has been achieved. Such a fixing of the carriage 62 to the base frame 60 of the roller body 22 can, for example, be carried out in a particularly simple manner with the aid of a set screw (not shown in Fig. 16) screwed into a threaded bore of the carriage 62, which frictionally engages with the base frame 60 in order to clamp the carriage 62 in its respectively set longitudinal position along the second rotational axis RA2 on the base frame 60.

An arrangement for holding substrates curved along a main extension direction is adapted to be received in a vacuum chamber of a coating apparatus vis-à-vis to an evaporation source, and comprises a hub portion rotatably drivable about a first rotational axis, arm members radially extending away therefrom, and roller bodies mounted on the arm members so as to be rotatably drivable about second rotational axes. The roller bodies carry fixtures for holding the substrates with their main extension directions transverse to the respective second rotational axis, each arranged tiltable relative to the roller body about a tilt axis running transversely to said second rotational axis, so that an angle between a surface normal in a center of the held substrate and a perpendicular on said second rotational axis passing through the center can be adjusted.

### REFERENCE NUMERAL LIST

- 10: substrate holder arrangement
- 12: vacuum coating apparatus
- 14: vacuum chamber
- 16: evaporation source
- 18: hub portion
- 20: arm member
- 22: roller body
- 24: fixture
- 26: first driving device
- 28: second driving device
- 30: wheel
- 32: circular rail
- 34: vertical support
- 36: fixing device
- 38: first screen
- 40: hinge mechanism
- 42: sliding joint
- 44: longitudinal end
- 46: longitudinal end
- 48: coulisse slot
- 50: coulisse carrier
- 52: guide portion
- 54: coulisse pin
- 56: scale
- 58: point on the evaporation source
- 60: base frame
- 62: carriage
- 64: entraining mechanism
- 66: fork joint
- 68: gear mechanism
- 70: bevel gear pairing
- 72: eccentric drive
- 74: first bevel gear
- 76: second bevel gear
- 78: push rod
- 80: first end of push rod
- 82: second end of push rod
- 84: base of carriage
- 86: spacer
- 88: circular arc

- α: angle of tilting about tilt axis
- r: distance between substrate and evaporation source

- CE: center
- CM: coating material
- DC: discontinuity of substrate
- DD: transverse direction
- IC: angle of inclination
- MD: main extension direction of substrate
- PP: perpendicular on second rotational axis
- RA1: first rotational axis
- RA2: second rotational axis
- RA3: third rotational axis
- SD: secondary extension direction of substrate
- SF: surface to be coated
- SN: surface normal
- SS: substrate
- TA: tilt axis

## Claims

1. Substrate holder arrangement (10) for holding substrates (SS) curved at least along a main extension direction (MD) during a vacuum coating process, said substrate holder arrangement (10) being adapted to be received in a vacuum chamber (14) of a vacuum coating apparatus (12) opposite and spaced from an evaporation source (16), so that coating material evaporated from said evaporation source (16) can impinge on surfaces (SF) to be coated of the substrates (SS) held by said substrate holder arrangement (10), said substrate holder arrangement (10) comprising: a hub portion (18) rotatably drivable about a first rotational axis (RA1), which can be positioned in a defined manner with respect to said evaporation source (16), at least one arm member (20) extending away from said hub portion (18) in a radial direction with respect to the first rotational axis (RA1) as seen in a top view, and at least one roller body (22) which is mounted on said arm member (20) so as to be rotatably drivable about a second rotational axis (RA2) extending along said arm member (20), and that carries at least one fixture (24) for holding the substrate (SS) in an orientation in which the main extension direction (MD) of the substrate (SS) is substantially transverse to the second rotational axis (RA2), **characterized in that** said fixture (24) for holding the substrate (SS) is arranged tiltable relative to said roller body (22) about a tilt axis (TA) which runs substantially transversely to the second rotational axis (RA2), so that an angle (α) between a surface normal (SN) in a center (CE) of the surface (SF) to be coated of a substrate (SS) held by said fixture (24) and a perpendicular (PP) on the second rotational axis (RA2) passing through the center (CE) can be adjusted.

2. Substrate holder arrangement (10) according to claim 1, **characterized in that** said at least one fixture (24) is mechanically positively forcibly guided with respect to said roller body (22) via a hinge mechanism (40) so as to be pivotable with respect to the tilt axis (TA).

3. Substrate holder arrangement (10) according to claim 2, **characterized in that** said hinge mechanism (40) comprises at least one sliding joint (42) which has, between said fixture (24) and said roller body (22), a coulisse carrier (50) with at least one coulisse slot (48) which is curved in an arc of a circle about the tilt axis (TA) and in which a guide portion (52) is accommodated so as to be slidable but nonetheless non-rotatable with respect to said coulisse slot (48).

4. Substrate holder arrangement (10) according to claim 3, **characterized in that** said guide portion (52) is formed by two laterally spaced-apart coulisse pins (54) which permit a positively guided displacement of said guide portion (52) in said coulisse slot (48), but nevertheless prevent a rotation of said guide portion (52) in said coulisse slot (48).

5. Substrate holder arrangement (10) according to claim 3 or 4, **characterized in that** said coulisse carrier (50) with said coulisse slot (48) is attached to said roller body (22), while said guide portion (52) is provided on said fixture (24).

6. Substrate holder arrangement (10) according to any one of claims 3 to 5, **characterized in**
**that** said fixture (24) has opposite longitudinal ends (44, 46), as viewed in a direction transverse to the second rotational axis (RA2), at each of which a sliding joint (42) is provided, and/or
**that** a scale (56) is attached to said sliding joint (42), on which the angle (α) can be read by which said fixture (24) is tilted about the tilt axis (TA) with respect to said roller body (22), and/or
**that** said sliding joint (42) is designed to allow a tilting of said fixture (24) with respect to said roller body (22) from -20 degrees to +20 degrees about the tilt axis (TA), wherein the angular position of 0 degrees for said fixture (24) is selected such that, when said fixture (24) faces the evaporation source (16), the surface normal (SN) at the center (CE) of the surface (SF) to be coated of a substrate (SS) held on said fixture (24) points substantially to a point (58) on the evaporation source (16) .

7. Substrate holder arrangement (10) according to any one of the preceding claims, **characterized in**
**that** said fixture (24) is adapted to be statically fixable with respect to said roller body (22) at a predetermined tilt angle (α) about the tilt axis (TA), in which said fixture (24) remains during an actual coating process of a substrate (SS) held on said fixture (24), or
**that** said fixture (24) is arranged such that it can be tilted dynamically about the tilt axis (TA) with respect to the roller body (22) during the rotation of said roller body (22) about the second rotational axis (RA2), so that a substrate (SS) held on said fixture (24) can be rotated about the second rotational axis (RA2) and tilted in an oscillating manner about the tilt axis (TA) at the same time during the actual coating process.

8. Substrate holder arrangement (10) according to claim 7, **characterized in that** said roller body (22) has a base frame (60) which is mounted on said arm member (20) such that it can rotate about the second rotational axis (RA2) and on which a carriage (62) is guided such that it can be displaced longitudinally along the second rotational axis (RA2), said coulisse carrier (50) of said at least one sliding joint (42) being mounted on said base frame (60), while an entraining mechanism (64) is arranged between said carriage (62) and said fixture (24), said entraining mechanism (64) being adapted to tilt said fixture (24) in said sliding joint (42) about the tilt axis (TA) in the event of a longitudinal displacement of said carriage (62) with respect to said base frame (60).

9. Substrate holder arrangement (10) according to claim 8, **characterized in that** said entraining mechanism (64) between said carriage (62) and said fixture (24) has a fork joint (66) via which said fixture (24) can be driven to tilt about the tilt axis (TA) .

10. Substrate holder arrangement (10) according to any one of claims 7 to 9, **characterized by** a gear mechanism (68) for forced coupling of the rotational movement of said roller body (22) about the second rotational axis (RA2) and the tilting movement of said fixture (24) about the tilt axis (TA).

11. Substrate holder arrangement (10) according to claim 10, **characterized in**
**that** said gear mechanism (68) for forced coupling of the rotational movement of said roller body (22) about the second rotational axis (RA2) and the tilting movement of said fixture (24) about the tilt axis (TA) is adapted to convert the rotational movement of said roller body (22) into an oscillating longitudinal movement of said carriage (62) on said base frame (60) of said roller body (22), and/or
**that** said gear mechanism (68) for forced coupling of the rotational movement of said roller body (22) about the second rotational axis (RA2) and the tilting movement of said fixture (24) about the tilt axis (TA) has a bevel gear pairing (70) and an eccentric drive (72), said bevel gear pairing (70) having a first bevel gear (74) which is mounted fixedly in terms of rotation on said arm member (20) and meshes with a second bevel gear (76) which is mounted on said base frame (60) of said roller body (22) so as to be rotatable about a third rotational axis (RA3) which runs perpendicularly to the second rotational axis (RA2), and to which a push rod (78) of said eccentric drive (72) is articulated eccentrically with respect to the third rotational axis (RA3) by one end (80), the other end (82) of said push rod (78) being articulated to said carriage (62) of said roller body (22), and/or
**that** a transmission ratio of said gear mechanism (68) for forced coupling of the rotational movement of said roller body (22) about the second rotational axis (RA2) and the tilting movement of said fixture (24) about the tilt axis (TA) is selected in such a way that said fixture (24) swivels back and forth about the tilt axis (TA) with a frequency that is not an integer number and lies between 0.5 and 2.5 per revolution of the roller body (22) about the second rotational axis (RA2).

12. Substrate holder arrangement (10) according to any one of the preceding claims, **characterized by** a plurality of fixtures (24) arranged mirror-symmetrically on said roller body (22) with respect to a plane containing the second rotational axis (RA2).

13. Substrate holder arrangement (10) according to claim 12, **characterized in that** each of said fixtures (24) is associated with a fork joint (66) of said entrainment mechanism (64), each fork joint (66) being attached to said carriage (62) of said roller body (22) for a common movement with respect to said base frame (60) of said roller body (22).

14. Substrate holder arrangement (10) according to claim 12 or 13, **characterized in that** said fixtures (24) are arranged on said roller body (22) with the aid of spacers (86), while said coulisse slots (48) of said sliding joints (42) are arranged at different heights of said coulisse carrier (50), so that, in a state of the substrate holder arrangement (10) installed in the vacuum chamber (14) of a vacuum coating apparatus (12), when said fixtures (24) provided on one side of the second rotational axis (RA2) face the evaporation source (16) in said vacuum chamber (14), the tilt axes (TA) of said fixtures (24) lie on a circular arc (88) in the center of which said evaporation source (16) is located.

15. Vacuum coating apparatus (12) comprising a vacuum chamber (14), in which an evaporation source (16) is arranged, **characterized in that** a substrate holder arrangement (10) according to any one of the preceding claims is received in said vacuum chamber (14) opposite and spaced from said evaporation source (16), so that coating material evaporated from said evaporation source (16) can impinge on surfaces (SF) to be coated of the substrates (SS) held by said substrate holder arrangement (10) .
